# EUROPEAN PATENT SPECIFICATION

(11) **EP 1 090 159 B1**
(45) Date of publication and mention of the grant of the patent: **11.03.2009**
(21) Application number: 98953847.5
(22) Date of filing: 20.10.1998
(51) Int. Cl.: C23C 8/00, C23C 16/00, H05H 1/24

(54) **DEPOSITION OF COATINGS USING AN ATMOSPHERIC PRESSURE PLASMA JET**
AUFBRINGEN VON BESCHICHTUNGEN MIT EINEM PLASMASTRAHL UNTER ATMOSPHÄRENDRUCK
DEPOT DE REVETEMENTS A L'AIDE D'UN JET DE PLASMA A PRESSION ATMOSPHERIQUE

(30) Priority: 20.10.1997 US 62822 P
(43) Date of publication of application: 11.04.2001
(73) Proprietor: The Regents of the University of California, Los Alamos, NM 87545 (US); Babayan, Steve E., Huntington, Beach, CA 92648 (US); Selwyn, Gary S., Santa Fe, NM 87505 (US); Hicks, Robert F., Los Angeles, CA 90024 (US)
(72) Inventor: BABAYAN, Steve, E., Huntington Beach, CA 92648 (US); SELWYN, Gary, S., Santa Fe, NM 87505 (US); HICKS, Robert, F., Los Angeles, CA 90024 (US)
(74) Representative: Johnson, Richard Alan
(86) International application number: PCT/US1998/022306
(87) International publication number: WO 1999/020809

(56) References cited:
- EP-A- 0 624 897
- WO-A-98/35379
- DE-A- 3 014 258
- US-A- 5 256 205
- US-A- 5 369 336
- US-A- 5 370 737
- US-A- 5 648 147
- US-A- 5 648 147
- BABAYAN S E ET AL: "Deposition of silicon dioxide films with an atmospheric-pressure plasma jet" PLASMA SOURCES SCI. TECHNOL. (UK), PLASMA SOURCES, SCIENCE AND TECHNOLOGY,, vol. 7, no. 3, August 1998 (1998-08), pages 286-288, XP001196924 IOP PUBLISHING, UK ISSN: 0963-0252

## Description

### FIELD OF THE INVENTION

The present invention relates generally to plasma-enhanced, chemical vapor deposition of coatings and, more particularly, to the use of an atmospheric-pressure, plasma discharge jet for deposition of films on substrates. This invention was made with government support under Contract No. W-7405-ENG-36 awarded by the U.S. Department of Energy to The Regents of the University of California. The government has certain rights in the invention.

### BACKGROUND OF THE INVENTION

Silicon dioxide is one of the primary materials used in integrated circuit production. Silicon dioxide films are used for inter layer dielectrics and gate oxides for transistors and are presently either grown by thermal oxidation of silicon or deposited by thermal or plasma-enhanced, chemical vapor deposition. Plasma-enhanced, chemical vapor deposition (PECVD) is often preferred since deposition temperatures are considerably lower than other methods.

The use of silane to deposit silicon dioxide films has been studied in detail. However, PECVD of silicon dioxide using tetraethoxysilane (TEOS) has been found to have several advantages over silane-based CVD processes. Although higher deposition rates are achieved with silane, better conformal coverage of device is obtained with TEOS due to its lower reactive sticking probability on surfaces (0.045 compared to 0.35 for silane). In addition, TEOS is less hazardous and easier to handle when compared with silane. With the increasing importance of smaller features, step coverage has become an important issue as well. Thus, TEOS has become the primary material for multilevel interconnects in very large-scale, integrated circuit (VLSI) applications. Thermal CVD of silicon dioxide is often carried out with TEOS and Ozone. In this process, the deposition is believed to result from the reaction of TEOS and O or O₃ in the gas phase. The atomic oxygen is maintained by the decomposition of O₃. Plasma-enhanced, chemical vapor deposition of SiO₂ is currently performed using TEOS and a reactive oxygen source which contains o atoms O₂⁺ ions.

DE 3014258 discloses a method of depositing metallic, metalloid or ceramic layers on a substrate using atmospheric pressure plasma spraying.

US 5369336 discloses a method of etching using a low-temperature discharging plasma.

Conventional, low-pressure plasma discharges produce ions and atomic species which may damage underlying layers during the film deposition process. Since atmospheric operation offers certain advantages over vacuum processes, we decided to explore whether the plasma jet could be used for PECVD of SiO₂.

Accordingly, it is an object of the present invention to generate an intense flux of metastable and radical species for use in plasma-enhanced, chemical vapor deposition onto a substrate without exposing the substrate to ionic and atomic species.

Another object of the invention is to generate an intense flux of metastable and radical species for use in plasma-enhanced, chemical vapor deposition onto a substrate at atmospheric pressure.

Yet another object of the present invention is to generate an intense flux of metastable and radical species for use in plasma-enhanced, chemical vapor deposition onto a substrate at atmospheric pressure without significantly heating the substrate.

Additional objects, advantages and novel features of the invention will be set forth in part in the description which follows, and in part will become apparent to those skilled in the art upon examination of the following or may be learned by practice of the invention, The objects and advantages of the invention may be realized and attained by means of the instrumentalities and combinations particularly pointed out in the appended claims.

### SUMMARY OF THE INVENTION

To achieve the foregoing and other objects and, in accordance with the purposes of the present invention as embodied and broadly described herein, the method for depositing a material on a substrate is described in claim 1.

Preferably, substantially all ions produced in the atmospheric-pressure, plasma discharge are consumed in the discharge before the gaseous jet containing the material exits through the open end of the chamber.

In another aspect of the present invention, in accordance with its objects and purposes, the apparatus for depositing a material onto a substrate is described in claim 7.

It is preferred that the central electrode is disposed collinear with the axis of the chamber.

It is also preferred that the electrode has longitudinal slots therein, each slot having a chosen width and a chosen depth.

Preferably also, substantially all ions generated in the atmospheric-pressure, plasma discharge are consumed therein before the gaseous jet containing said material exits through the open end of said chamber.

Benefits and advantages of the present invention include the generation of an intense beam of the material to be deposited without exposing the substrate to ions and atomic species and to a high-temperature source.

### BRIEF DESCRIPTION OF THE DRAWINGS

The accompanying drawings, which are incorporated in and form a part of the specification, illustrate the embodiments of the present invention and, together with the description, serve to explain the principles of the invention. In the drawings:
FIGURES 1a-c illustrate the atmospheric-pressure, plasma jet of the present invention, Fig. 1 a showing a cross sectional view of thereof, with Figs. 1b and 1c illustrating the side view and the axial cross section of the center electrode thereof.
FIGURE 2 shows the effect of RF power and TEOS partial pressure on the SiO₂ deposition rate.
FIGURE 3 shows the SiO₂ deposition rate as a function of substrate temperature.
FIGURE 4 shows the effect of helium flow rate on the deposition rate of SiO₂ and on the ozone concentration.
FIGURE 5 shows the effect of oxygen partial pressure on the deposition rate
FIGURE 6 shows FT-IR absorption spectra of SiO₂ films deposited at different substrate temperatures.
FIGURE 7a shows an AFM image of an SiO₂ film deposited for 10 min. at 115 °C, while FIGURE 7b shows an AFM image of an SiO₂ film deposited for 10 min. at 350°C.

### DETAILED DESCRIPTION OF THE INVENTION

Briefly, the present invention utilizes a plasma discharge sustained at atmospheric pressure and near room temperature to deposit films on substrates. A feed gas containing helium and oxygen is caused to enter the annular region between two coaxial electrodes and produces a stable atmospheric pressure plasma jet (APPJ). The jet differs from conventional low-pressure plasma sources in that it produces an intense flux of metastable and radical species instead of ions and atomic species. While ions and atomic species are generated inside the APPJ, they are rapidly consumed by collisions before exiting the space between the electrodes. As an example of the coating process of the present invention, tetraethoxysilane (TEOS), an SiO₂ precursor species which reacts with metastable oxygen, is introduced into the flux thereof in helium gas outside of the space between the electrodes, generating thereby a substantial concentration of SiOₓ species. These species generate an SiO₂ film upon impinging on a silicon substrate. The absence of ions and atoms eliminates the possibility of damaging the underlying layer of the substrate during deposition.

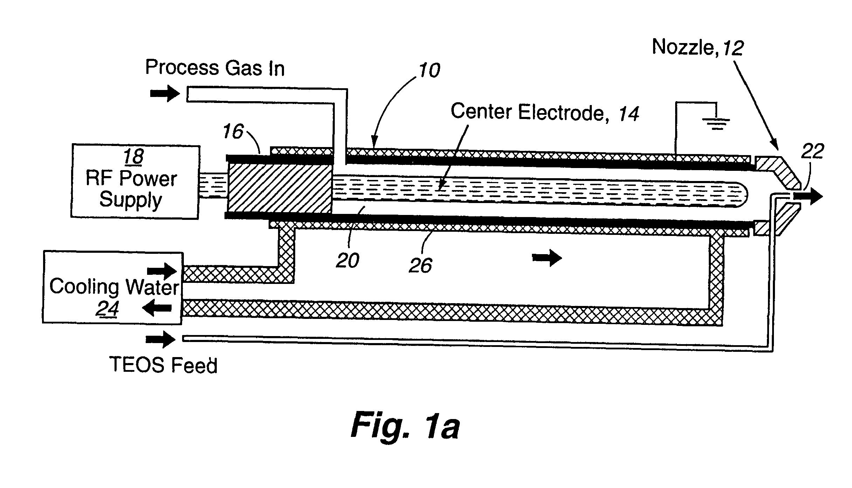

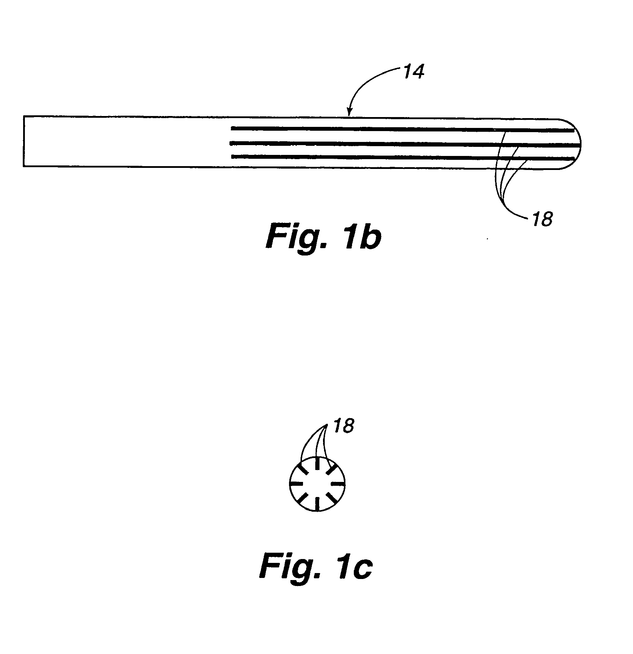

Reference will now be made in detail to the present preferred embodiments of the present invention examples of which are illustrated in the accompanying drawings. Turning now to the Figures, Figs. 1 a and 1b are schematic representations of side views of the assembled APPJ of the present invention and the center electrode thereof, respectively, which is used to deposit silicon dioxide and other films onto substrates. The APPJ consists of two concentric electrodes made of stainless steel. Figure 1c is a schematic representation of the axial cross section of the center electrode showing the longitudinally placed slots or flutes therein. In one embodiment, each identical flute has a width dimension and a depth dimension, typically between 0.05 and 0.25 cm (0.02 and 0.1 in). It is preferred that the ratio of the width dimension to the depth dimension of the flutes is approximately one-to-three. The use of such slots has been found to produce an enhanced plasma density that provides a broader operating window without arcing than for the same conditions using a solid, center electrode; that is, the apparatus can operate over a wider He/O₂ mixture range and at higher RF power without arcing. Radio frequency power at 13.56 MHz was applied to the inner electrode. Unlike atmospheric pressure glow discharges, the APPJ does not require a dielectric material between the electrodes to create a stable plasma. The inner (center) electrode employed had a diameter of to cm (0.50"), while the outer electrode had an inner diameter of 1.57 cm (0.62"). Oxygen and helium gas flow rates were measured with rotameters and the gases were mixed before entering the annular space between the two electrodes. The TEOS carrier gas, helium, was regulated by a mass flow controller. This carrier gas was bubbled through a reservoir of TEOS at a fixed temperature. The resulting mixture was combined with the flowing plasma gases inside a nozzle placed at the open end of the jet. This nozzle directed the effluent flow toward the substrate to be coated.

The SiO₂ films were deposited on ρ-type silicon wafers which were placed 1 to 3 cm away from the nozzle. Prior to deposition, the silicon wafers were first cleaned in boiling sulfuric acid, and subsequently immersed in dilute hydrofluoric acid for 30 seconds. After a thorough rinse, the substrates were placed on a sample holder disposed in front of the jet and a temperature between 85 and 350°C was chosen and maintained. Temperature measurements were made using a thermocouple placed 1 mm behind the sample surface. After the temperature had stabilized, the helium and oxygen flow rates were established and the RF power between 75 and 500W was applied to the electrodes forming a stable discharge. Flow of the TEOS carrier gas was then initiated, allowing the TEOS/helium mixture to combine with the effluent stream. Unless otherwise noted, the standard process conditions were: P_{Hc} = 100950 Pa (757.2torr), P_{O2} = 370 Pa (2.8torr), P_{TEOS} = 0.95 Pa (7.1 mtorr), total flow rate = 49.4 L/min, T_{substrate} = 115°C, nozzle to sample distance = 1,7 cm, RF power = 280W. After deposition, the films were analyzed to assess their quality.

Optical emission spectroscopy (OES) was used to detect the presence of oxygen atoms, ions, and metastables outside of the jet. The emission detector was disposed and focused perpendicular to the effluent stream. In addition, ozone concentrations were measured by an electrochemical gas monitor. The gas monitor was connected to a 0.025 cm (1/16") stainless steel tube placed into the exiting gas stream (not shown in Figs 1 a-c hereof). This allowed for continuous sampling of the effluent stream as the process conditions were changed. After deposition, the film composition was analyzed by infrared spectroscopy, the film thickness and the refractive index were measured by ellipsometry, and the surfaces were imaged by atomic force microscopy. The dielectric constant was also calculated from capacitance data by constructing a parallel plate capacitor of known plate area and separation.

Having generally described the invention, the following examples provide more detail:

### EXAMPLE 1

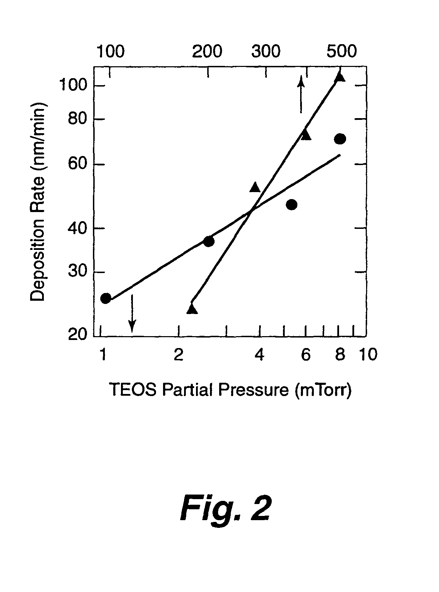

The effects of the TEOS partial pressure and the RF power on the deposition rate are shown in Figure 2. The TEOS partial pressure was varied from 0.1 to 1.0 Pa (1 to 8 mtorr) and RF power levels were between 180 and 500 W. At an RF power of 500 watts, the temperature of the sample holder (not shown in . Figs. 1a-c hereof), which was located 1.5 cm away from the nozzle, was found not to rise above 115°C. This demonstrates the non-thermal nature of the APPJ. The log-log representation of the data shown in Fig. 2 indicates that the reaction order for the TEOS partial pressure is 0.47, whereas the reaction order for the RF power is 1.41. The reaction order for the RF power was found to be the largest of any process variable, while the second largest contribution to the deposition rate derives from the TEOS partial pressure. By increasing both the TEOS partial pressure to 27 Pa (0.2 torr) and the RF power to 400 W, silica films were grown at 302 ± 25 nm/min (3020 ± 250 Å/min). It is believed by the present inventors that this value may be limited by the small bubbler which can only receive 200 sccm of the carrier gas.

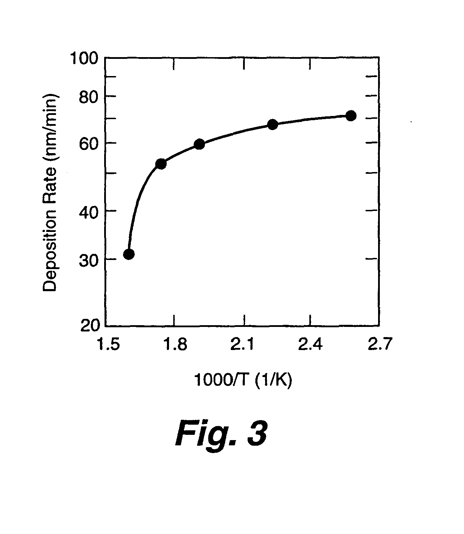

An increase in the sample temperature with all other process conditions held constant shows a decrease in the deposition rate. Without additional heating of the sample, a temperature of 107 °C was maintained by the presence of the plasma at the standard operating conditions. A plot of the logarithm of the deposition rate as a function of 1000/T is shown in Fig. 3. The plot is not linear indicating the departure from the Arrhenius form.

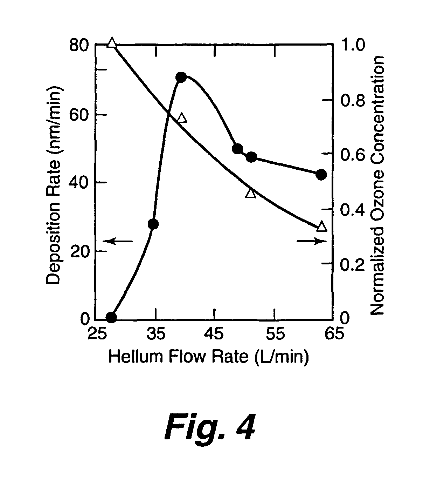

The gas mixture entering the APPJ is primarily composed of helium. The helium flow rate was typically 49 L/min. The effect of the deposition rate on the helium flow is shown in Fig. 4, A maximum is obviously present at 40.2 L/min. The decrease in ozone concentration with increasing helium flow rate is also shown in Fig. 4 for comparison. The deposition rate and ozone concentration as functions of helium flow rate show no correlation.

The metastable oxygen intensity decays with increasing distance from the jet. Axial analysis of the effluent stream with OES has shown that metastable oxygen (b¹Σ_{g}⁺) is the dominant reactive species.

The metastable species persist for more than 2 cm beyond the jet, whereas the weak atomic oxygen signal is only present within 1.5 cm of the jet.

A long nozzle was constructed to extend the outer electrode 4.2 cm beyond the center electrode to permit detection of ozone at varying distances without the dilution effect from the expansion of the jet stream as it exits the nozzle. The effect of the introduction of TEOS at different axial distances was then correlated with the axial flux profiles of metastable oxygen and ozone outside the APPJ. To determine whether it is the O₃ or the O₂(b¹Σ_{g}⁺) that is responsible for the gas-phase dissociation of TEOS, the TEOS was introduced at two different distances from the center electrode.

In both cases, the substrate was 1.7 cm away from the TEOS feed. The deposition rate for Case I, where the TEOS feed was placed 1.1 cm from the center electrode, was twice that of Case II, where the TEOS feed was placed at 3.7 cm and the ozone concentration was high. As stated hereinabove, the SiO₂ is formed once the reaction products have been deposited onto the silicon substrate.

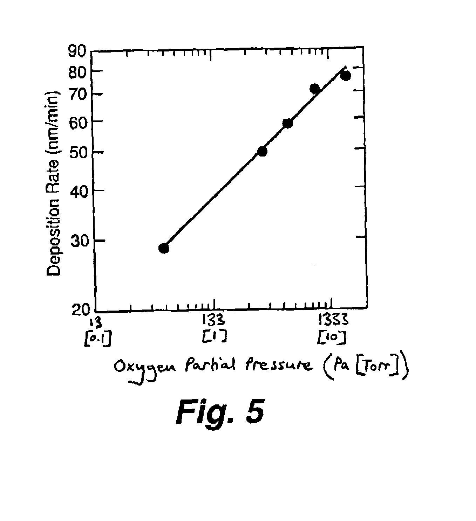

Figure. 5 shows the effect of the oxygen partial pressure on the deposition rate. For this Figure, the oxygen was passed through the plasma jet. This data indicates that the reaction order for oxygen is 0.28. Oxygen must be present for the reaction to proceed. This differs from an atmospheric-pressure glow discharge, which can deposit silicon dioxide in a helium plasma without the presence of oxygen.
O₂(b¹Σ_{g}⁺) signal intensity decreases with increasing oxygen partial pressure. This trend is opposite that of the deposition rate dependence on the oxygen partial pressure. In other experiments, oxygen was introduced only through the nozzle where the TEOS was introduced. When the oxygen is delivered in this manner, metastable oxygen is not produced. Introducing the oxygen through the nozzle only, results in deposition rates that are less than one-tenth of the rates achieved when the same amount of oxygen is passed through the plasma jet.

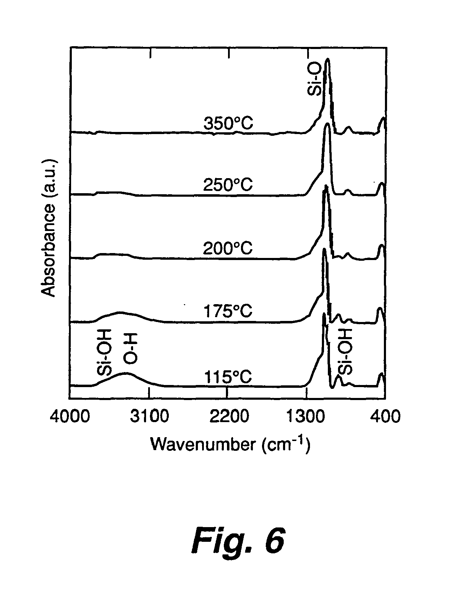

The infrared spectra in Fig. 6 show the effect of temperature on the film quality. The Si-O-Si asymmetric stretching, bending, and rocking modes are observed at 1080, 800, and 450 cm⁻¹, respectively. The absorption due to Si-O-H is observed at 3650 cm⁻¹. Hydrogen bonding between Si-O-H and H₂O is observed at 3400 and 930 cm⁻¹. The peaks located at 3650, 3400, and 930 cm⁻¹ all decrease with increasing growth temperature. The CH stretching mode at 2900 cm⁻¹ and the C=O stretching mode at 1730 cm⁻¹ were not observed.

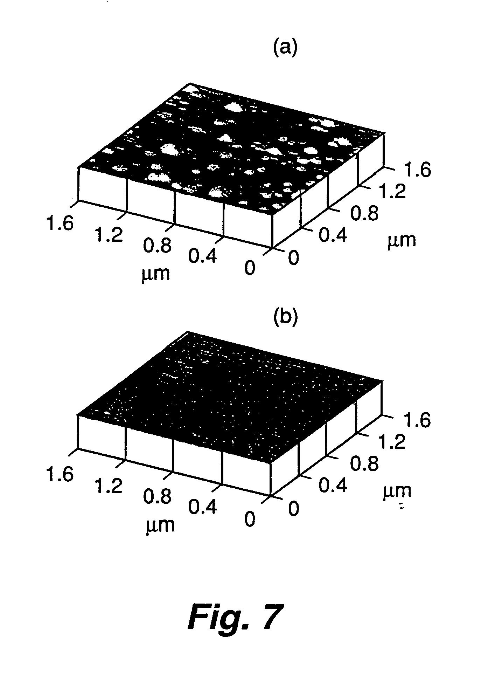

The films deposited at 115°C have 0.1-0.3 µm circular features on the film surface. Figure 7a. shows an atomic force microscope image of such a surface. The white regions represent material protruding out of the plane of the deposited film. The peak-to-valley roughness is approximately 230 nm (2300 Å). The z-axis is magnified by a factor of 5 to emphasize these surface features. Figure 7b shows an atomic microscope image for a film deposited at 350 °C. The surface is featureless. The peak-to-valley roughness is approximately 2 nm (20 A).

The refractive index squared, measured by ellipsometry, did not show a significant change from sample to sample. The square of the refractive index was 1.45 ± 0.02 for most samples. To better asses the film quality, the dielectric constant was calculated from capacitance data for several films deposited by this process. From capacitance data, the dielectric constants were found to range from 5.0 ± 0.2 for films deposited below 150°C to 3.81 ± 0.03 for films deposited at 350 °C, indicating that excellent dielectric properties are attainable.

Both the high flow velocity and the use of helium, which limits ionization, prevents arcing in the APPJ. Figure 4 shows that the deposition rate reaches a maximum with a helium flow rate of 40.2 L/min. Although the oxygen and TEOS partial pressures were not constant in Fig. 3, the maximum is a result of the balance between the production of reactive species in the plasma stream, and the residence time of the TEOS in the plasma stream. Below this point, the number of reactive species produced within the plasma decreases. At 50 L/min of helium, the linear velocity exiting the jet is greater than 26 m/s. This does not provide sufficient time for the gas-phase reaction to occur before the substrate, 2 cm away, is reached. The slow decay of the curve with increasing helium flow rate is evidence nt the effect of the TEOS residence time in the plasma.

The plasma can be sustained at approximately 40 watts of forward power. With the present APPJ design, application of an RF power exceeding 500 watts generally produces arcing which can physically damage the electrodes. The large value of 1.41 for the slope of the log-log plot of the deposition rate as a function of the RF power confirms the strong dependence of the deposition rate on the amount of reactive species generated by the APPJ. The increase of the deposition rate with increasing power indicates that complete conversion is not achieved. This demonstrates the role of the collision frequency between the TEOS and the reactive species on the deposition rate, since increasing the power increases the concentration of reactive species in the jet effluent.

The dependence of the deposition rate on the helium flow rate, applied RF power, and TEOS flow rate all demonstrate that the deposition process is limited by gas-phase reactions in the plasma stream. However, upon increasing the substrate temperature, the deposition rate decreases substantially. Chemical vapor deposition using TEOS and oxygen is characterized by a negative activation energy. The deposition process is known to be exothermic. Additionally, increasing the substrate temperature will shift the adsorption equilibrium to the left. It is believed by the present inventors that the exothermic nature of the surface reaction and decrease in the effective adsorption of the TEOS on the substrate surface likely both contribute to the positive slope observed in Fig. 3. Films deposited at low temperatures are less dense. Since the deposition rate was measured from the film thickness, the deposition rate of these less-dense films will appear slightly higher than the more dense films grown at higher temperatures. This difference impacts the plot shown in Fig. 3 by slightly reducing the curvature.

As stated hereinabove, the APPJ effluent contains no ions. At atmospheric pressure, the ions are rapidly consumed upon exiting the annular space between the electrodes. Thus, helium metastables, oxygen atoms, ozone, or oxygen metastables are the only reactive species which could be responsible for the gas phase decomposition of the TEOS. The measured atomic oxygen concentration outside the APPJ is too small to contribute significantly to the deposition rate. The present inventors believe that helium metastables are not directly responsible for the gas phase decomposition of TEOS, since deposition is not observed without the presence of oxygen. In a helium APG process, without the addition of oxygen, silicon dioxide is deposited using TEOS as both the silicon and oxygen source. The lack of correlation between the deposition rate and ozone concentration illustrated in Fig. 4 indicates that ozone plays little if any role in the deposition process using the atmospheric pressure plasma jet.

The discussion set forth hereinabove suggests that metastable O₂(b¹Σ_{g}⁺) or O₂(a¹Δ_{g}⁺), is responsible for the gas-phase decomposition of TEOS which drives the deposition process. The ten-fold decrease in the deposition rate when oxygen is introduced only into the nozzle, in which metastable oxygen is not produced, is evidence of the important role of metastable oxygen in the reaction mechanism.
Some correlation exists between O₂(b¹Σ_{g}⁺) intensity and deposition rate with increasing distance from the jet.

Optical emission spectroscopy does not give a quantitative measure of the species present; rather, it detects electronic transitions. Thus, it cannot be determined that the O₂(b¹Σ_{g}⁺) concentration has the same trend as the detected intensity, or that O₂(b¹Σ_{g}⁺) plays no role in the deposition process. It is likely that the O₂(a¹Δ_{g}⁺) metastable state may be the active species present in the jet effluent, since previous work in solutions and gas mixtures by others have shown that the consumption of O₂(b¹Σ_{g}⁺) by chemical reaction is insignificant when compared to deactivation to produce O₂(a¹Δ_{g}⁺) in solution.

Generally, increasing the temperature and incorporating H₂ into the gas stream increases the film quality by removing carbon and hydroxyl groups from the film, The increase in growth temperature reduces the hydroxyl concentration in the films, as may be observed from the infrared spectra of Fig. 6 The peaks located at 3650, 3400, and 930 cm⁻¹ all decrease with increasing deposition temperature. The CH and C=O stretching vibrations are not present in the infrared spectra collected for any of the films deposited. However, it should be mentioned that upon addition of an amount as small as 0.25% of hydrogen, no deposition occurred even after 20 minutes.

Undesirable surface features were observed on the films deposited by the APPJ when the substrate temperature was maintained at 115 °C. The AFM image shown in Fig. 7a reveals surface defects due to voids within the deposited silicon dioxide film. As shown in Fig. 7b , films deposited at 350 °C were smooth, suggesting the absence of voids. At low substrate temperatures the energy supplied to the surface atoms is too small for significant surface migration. Therefore, the siloxane chains deposited on the substrate may not have sufficient time to arrange. Thus, a void can form around a protruding siloxane chain or cluster. At higher growth temperature the surface migration prevents the voids from forming during deposition. In addition, the shoulder located at 1200 cm⁻¹, to the Si-O-Si asymmetric stretching mode increases with decreasing temperature as shown in Fig. 6. This may be from an increase in the porosity of the deposited films. Generally, the dielectric-screening effect reduces the vibration frequency. This effect is diminished near the surface of a large void. The Si-O-Si vibrations facing a large void or the film surface are not subject to the dielectric screening effect, and thus their vibrational frequency is not shifted.

The dielectric constant of silica generally obeys the equation ε = 3.8073 + 2.72 x 10⁻²² x N, where N is the concentration of hydroxyl ions per cubic centimeter. In the limit where no hydroxyl ions are present, such as in a thermally grown oxide, the dielectric constant will be 3.8073. The measured dielectric constants for the films deposited varied from 3.81 ± 0.03 to 5.0 ± 0.2 indicating hydroxyl concentrations of 9.93 x 10¹⁸ and 4.38 x 10²¹ hydroxyl ions per cubic centimeter, respectively. The increase in the sample temperature promotes the desorption of H₂O produced in the formation of silicon dioxide from TEOS. However, the increase in temperature reduces the deposition rate. Thus, the deposition rate desired and the dielectric constant required for a particular application are balanced by the substrate temperature.

### EXAMPLE 2

Suitable precursors for depositing a film containing a metal atom M are MLₓ (where Lₓ is a ligand and x is the valence of the metal atom) compounds that are (a) volatile, (b) stable for transport to the nozzle, and (c) decompose without depositing impurities in the film. Suitable precursors may be identified by simple experimentation. Suitable volatile compounds are generally those containing short-chain alkyl groups and alkoxides mentioned hereinbelow. However, halogens (e.g., chlorides), amines, phosphines, and carbonyl ligands are often suitable.

The Table identifies other thin films that should be able to be deposited with the plasma jet of the present invention. In all of these processes, helium will be introduced into the plasma. If an oxide is to be deposited, then O₂ is mixed with the helium and the mixture passed through the plasma. If a nitride is to be deposited, then either N₂ or NH₃ will be mixed with the helium and the mixture passed through the plasma. If a carbide is to be deposited, then either acetylene or methane will be mixed with the helium and the mixture passed through the plasma (other hydrocarbon gases, such as ethane, ethylene, etc. may be used as well).

For deposition of a pure elemental film, hydrogen may be passed through the plasma. The precursor containing the element to be deposited is always introduced into the nozzle following the plasma; otherwise, a film will be deposited on the electrodes and the plasma will extinguish. If an oxide film is to be deposited, then an alkoxide containing the element to be deposited will be introduced into the nozzle. Alkoxides have the general formula: M(OR)ₓ, where x is the number of alkoxide ligands which is equal to the valence of the metal atom, and R is an alkyl group attached to the oxygen atom. The alkyl group may include methyl, ethyl, n-propyl, isopropyl, n-butyl, isobutyl, tertiary butyl, allyl, vinyl, etc.

For depositing nitrides and carbides, an organometallic molecule containing the element to be deposited; i.e., MRₓ, where x is equal to the valence of the metal, would be employed. The alkyl group, R, is the same as described above. For example, to deposit GaN, N₂ and He would be passed through the plasma, and He and Ga(CH₃) introduced into the nozzle. Here the R group would be a methyl ligand. Other gallium precursors could be used as well; for example, Ga(N(CH₃)₂)₃ may be employed.

**TABLE**

| | **Film** | **Precursors and Gasses Used** |
|---|---|---|
| SiO₂ | Silicon Dioxide | Tetraethoxysilane (TEOS), TEOS/O₂, SiH₄/O₂, Si₂H₆/O₂, |
| Si(NMe₂)₄/O₂ | | |
| GeO₂ | Germanium Dioxide | Ge(CH₃)₄O₂. GeH₄/O₂. Ge(CH₃O)₄/O₂ |
| Al₂O₃ | Aluminum Oxide | Al(OC₃H₇)₃/O₂, Al(C₂H₅O)₃/O₂ |
| TiO₂ | Titanium Dioxide | Ti(C₂H₅O)₄/O₂, Ti(CH₃O)₄/O₂ |
| Si₃N₄ | Silicon Nitride | TEOS/N₂, SiH₄/N₂, TEOS/NH₃, SiH₄/NH₃, Si(NMe₂)₄/N₂ |
| BN | Boron Nitride | BF₃/N₂, BF₃/NH₃, B(C₂H₅)₃/N₂, B₂H₆/N₂, B₂H₆/NH₃ |
| GaN | Gallium Nitride | Ga(C₂H₅)₃/N₂, Ga(C₄H₉)₃/N₂, Ga(CH₃)₃/N₂, Ga(CH₃)₃/NH₃, |
| AIN | Aluminum Nitride | AlH₃N(CH₃/₂/N₂, Al(CH₃)₃/N₂, AlH(CH₃)/N₂, Al(CH₃)₃/NH₃ |
| TiN | Titanium Nitride | Ti(NMe₂)₄, Ti(NMe₂)₄/N₂, Ti(NMe₂)₄/NH₃, TiCl₄NH₃ |
| InN | Indium Nitride | In(CH₃)₃/N₂, In(C₂H₅)₃/N₂, In(CH₃)₃/NH₃, In(C₂H₅)₃/NH₃, |
| WNₓ | Tungsten Nitride | WCl₆/N₂, WClₑINH₃, W(CO)₆/NH₃, W(CO)₆/N₂ |
| SiO₂₋ₓF₂ₓ | Silicon oxy-fluoride | TEOS/O₂/F₂, SiH₄O₂/F₂, Si₂H₆O₂/F₂ |
| SiO₂₋ₓN_{2/3x} | Silicon oxy-nitride | TEOS/N₂/O₂, SiH₄/N₂/O₂, Si(NMe₂)₄/O₂ |
| SiC | Silicon Carbide | SiH(C₂H₅)₃/C₂H₂, SiH₄/C₂H₂, Si₂H₆/C₂H₂, SiH₄/CH₄ |
| TiC | Titanium Carbide | Ti(NMe₂)₄/C₂H₂, Ti(NMe₂)₄/CH₄, TiCl₄/CH₄ |
| WCₓ | Tungsten Carbide | WCl₆/C₂H₂, WCl₆/CH₄, W(CO)₆, W(CO)₆/C₂H₂ |
| C | Diamond | CH₄, C₂H₆, C₂H₄, C₂H₂ |
| Si^{#} | Silicon^{#} | SiH₄, Si₂H₆, SiH₄/H₂, Si₂H₆/H₂ |
| Cu | Copper | Cu(OCH₂CH₂NMe₂)₂, Cu(OCH₂CH₃)₂ |
| Al | Aluminum | AlH₃N(CH₃)₂/H₂, Al(CH₃)₃/H₂, |
| W | Tungsten | WCl₆/H₂, W(CO)₆/H₂ |

| | | |
|---|---|---|
| "Polycrystalline silicon, or amorphous hydrogenated silicon. | | |

Other films that can be deposited include metal phosphides (MP, e.g., BP, GaP, AIP, etc.) and metal arsenides (MAs, e.g., AlAs, GaAs, InAs, etc.). These films might be deposited as polycrystalline or amorphous hydrogenated layers. Precursors for zirconium nitride and carbide (ZrN, ZrC) may be identified by substituting Zr for Ti in the compounds in the right-hand column of the TABLE, since zirconium is in the same row of the Periodic Table as titanium. Similarly, precursors for tantalum nitride and carbide (TaNₓ and TaCₓ) may be identified by substitution of Ta for W in the right-hand column of the TABLE. However, since Ta is in the next row to the left of W in the Periodic Table, the same ligands might be used as those for W, except that one fewer ligand would be required; e.g., Ta(CO)₅.

The range of deposition temperatures is 100 to 1000 °C, with a preferable range of 250 to 500 °C.

The foregoing description of the invention has been presented for purposes of illustration and description and is not intended to be exhaustive or to limit the invention to the precise form disclosed, and obviously many modifications and variations are possible in light of the above teaching. The embodiments were chosen and described in order to best explain the principles of the invention and its practical application to thereby enable others skilled in the art to best utilize the invention in various embodiments and with various modifications as are suited to the particular use contemplated. It is intended that the scope of the invention be defined by the claims appended hereto.

## Claims

1. A method for depositing a material onto a substrate, comprising the steps of:
(a) generating a reactive species in an arcless, atmospheric-pressure, RF plasma discharge in a gas flowing through an annular region (20) between an electrically conducting chamber (16) having a closed end and an open end (22) and a central electrode (14) located within the chamber (16) and disposed such that the annular region (20) is defined therebetween, whereby said reactive species flow toward the open end (22) of the chamber (16);
(b) introducing a gaseous precursor species of said material into the reactive species in the region of the open end (22) of the chamber (16) and outside of the annular region (20), said gaseous precursor species being chosen such that said precursor species reacts with at least one of said reactive species, whereby a gaseous jet capable of forming said material exits through the open end (22) of the chamber (16); and
(c) placing said substrate in the path of the gaseous jet, whereby said material is deposited on said substrate.

2. The method for depositing a material onto a substrate as described in Claim 1, wherein generating the reactive species includes consuming substantial all ions generated in the atmospheric-pressure, plasma discharge before the gaseous jet exits through the open end (22) of the chamber (16).

3. The method for depositing a material onto a substrate as described in Claim 1, wherein said flowing gas includes an O₂/He mixture.

4. The method for depositing a material onto a substrate as described in Claim 3, wherein said gaseous precursor species includes tetraethoxysilane, and said material is SiO₂.

5. The method for depositing a material onto a substrate as described in Claim 3, wherein said substrate is silicon.

6. The method for depositing a material onto a substrate as described in Claim 3, wherein 13.56 MHz RF energy is applied to the central electrode (14), and the electrically conducting chamber (16) is grounded.

7. An apparatus for depositing a material onto a substrate, which comprises in combination:
(a) an electrically conducting chamber (16) having a closed end and an open end (22):
(b) a central electrode (14) located within said chamber (16) defining thereby an annular region (20);
(c) means for flowing gases through the annular region (20);
(d) means (18) for supplying RF energy to either of said central electrode (14) or said electrically conducting chamber (16) such that a continuous plasma discharge occurs between said electrode (14) and said chamber (16), whereby reactive species are generated which flow toward the open end (22) of said chamber (16); and
(e) means for introducing a gaseous precursor species of said material into the reactive species in the region of the open end (22) of the chamber (16) and outside of the annular region (20), said gaseous precursor species being chosen such that said precursor species reacts with at least one of said reactive species, whereby a gaseous jet capable of forming said material exits through the open end (22) of said chamber (16).

8. The apparatus for depositing a material onto a substrate as described in Claim 7, wherein said electrically conducting chamber (16) has a longitudinal axis and said central electrode (14) has a longitudinal axis, and whereby said central electrode (14) is disposed such that the longitudinal axis thereof is collinear with the longitudinal axis of said chamber (16).

9. The apparatus for depositing a material onto a substrate as described in Claim 7, wherein said electrode (14) has longitudinal slots therein, each slot having a chosen width and a chosen depth.

10. The apparatus for depositing a material onto a substrate as described in Claim 9, wherein each slot has the same width and the same depth and wherein the ratio of the chosen width to the chosen depth of the slots is approximately one-to-three.

11. The apparatus for depositing a material onto a substrate as described in Claim 9, wherein the chamber (16) and central electrode (14) are arranged to ensure that substantially all ions generated in the atmospheric-pressure, plasma discharge are consumed therein before the gaseous jet exits through the open end (22) of said chamber (16).

12. The apparatus for depositing a material onto a substrate as described in Claim 9, wherein the flowing gas includes an O₂/He mixture.

13. The apparatus for depositing a material onto a substrate as described in Claim 12, wherein said gaseous precursor species includes tetraethoxysilane, and said material is SiO₂.

14. The apparatus for depositing a material onto a substrate as described in Claim 12, wherein 13.56 MHz RF energy is applied to said central electrode, and said electrically conducting chamber is grounded.

15. The apparatus for depositing a material onto a substrate as described in Claim 12, wherein said substrate is silicon.

## Patentansprüche

1. Verfahren zur Abscheidung eines Materials auf ein Substrat, folgende Schritte umfassend:
(a) die Bildung einer reaktiven Spezies in einer bogenlosen HF-Plasmaentladung bei Atmosphärendruck in einem Gas, das durch einen ringförmigen Bereich (20) zwischen einer elektrisch leitenden Kammer (16) mit einem geschlossenen und einen offenen Ende (22) und einer zentralen Elektrode (14), die sich innerhalb der Kammer (16) befindet und so angeordnet ist, dass der ringförmige Bereich (20) dazwischen definiert ist, strömt, wodurch der Strom der reaktiven Spezies zu dem offenen Ende (22) der Kammer (16) hin fließt;
(b) die Einführung einer gasförmigen Vorläuferspezies des Materials in die reaktive Spezies in dem Bereich des offenen Endes (22) der Kammer (16) und außerhalb des ringförmigen Bereichs (20), wobei die gasförmige Vorläuferspezies so gewählt ist, dass die Vorläuferspezies mit zumindest einer der reaktiven Spezies reagiert, wodurch ein gasförmiger Strahl, der in der Lage ist, das Material zu bilden, durch das offene Ende (22) der Kammer (16) austritt; und
(c) die Platzierung des Substrats in den Weg des gasförmigen Strahls, wodurch das Material auf das Substrat abgeschieden wird.

2. Verfahren zur Abscheidung eines Materials auf ein Substrat nach Anspruch 1, worin die Bildung der reaktiven Spezies das Aufbrauchen im Wesentlichen sämtlicher während der Plasmaentladung bei Atmosphärendruck erzeugter Ionen umfasst, bevor der gasförmige Strahl durch das offene Ende (22) der Kammer (16) austritt.

3. Verfahren zur Abscheidung eines Materials auf ein Substrat nach Anspruch 1, worin das Strömungsgas ein O₂/He-Gemisch umfasst.

4. Verfahren zur Abscheidung eines Materials auf ein Substrat nach Anspruch 3, worin die gasförmige Vorläuferspezies Tetraethoxysilan umfasst und das Material SiO₂ ist.

5. Verfahren zur Abscheidung eines Materials auf ein Substrat nach Anspruch 3, worin das Substrat Silicium ist.

6. Verfahren zur Abscheidung eines Materials auf ein Substrat nach Anspruch 3, worin 13,56 MHz HF-Energie an die zentrale Elektrode (14) angelegt werden und die elektrisch leitende Kammer (16) geerdet ist.

7. Vorrichtung zur Abscheidung eines Materials auf ein Substrat, das Folgendes miteinander kombiniert umfasst:
(a) eine elektrisch leitende Kammer (16) mit einem geschlossenen und einem offenen Ende (22);
(b) eine zentrale Elektrode (14), die sich in der Kammer (16) befindet und **dadurch** einen ringförmigen Bereich (20) definiert;
(c) Mittel zum Fließenlassen von Gasen durch den ringförmigen Bereich (20);
(d) Mittel (18) zum Zuführen von HF-Energie zu entweder der zentralen Elektrode (14) oder zur elektrisch leitenden Kammer (16), sodass es zu einer kontinuierlichen Plasmaentladung zwischen der Elektrode (14) und der Kammer (16) kommt, wodurch reaktive Spezies gebildet werden, die zu dem offenen Ende (22) der Kammer (16) hin fließen; und
(e) Mittel zum Einführen einer gasförmigen Vorläuferspezies des Materials in die reaktive Spezies in dem Bereich des offenen Endes (22) der Kammer (16) und außerhalb des ringförmigen Bereichs (20), wobei die gasförmige Vorläuferspezies so gewählt ist, dass die Vorläuferspezies mit zumindest einer der reaktiven Spezies reagiert, wodurch ein gasförmiger Strahl, der in der Lage ist, das Material zu bilden, durch das offene Ende (22) der Kammer (16) austritt.

8. Vorrichtung zum Abscheiden eines Materials auf ein Substrat nach Anspruch 7, worin die elektrisch leitende Kammer (16) eine Längsachse aufweist und die zentrale Elektrode (14) eine Längsachse aufweist und wobei die zentrale Elektrode (14) so angeordnet ist, dass die Längsachse davon mit der Längsachse der Kammer (16) kollinear ist.

9. Vorrichtung zur Abscheidung eines Materials auf ein Substrat nach Anspruch 7, worin die Elektrode (14) Längsschlitze aufweist, wobei jeder Schlitz eine gewählte Breite und eine gewählte Tiefe aufweist.

10. Vorrichtung zur Abscheidung eines Materials auf ein Substrat nach Anspruch 9, worin jeder Schlitz dieselbe Breite und dieselbe Tiefe aufweist und worin das Verhältnis zwischen der gewählten Breite und der gewählten Tiefe der Schlitze etwa eins zu drei ist.

11. Vorrichtung zur Abscheidung eines Materials auf ein Substrat nach Anspruch 9, worin die Kammer (16) und die zentrale Elektrode (14) angeordnet sind, um sicherzustellen, dass im Wesentlichen sämtliche während der Plasmaentladung bei Atmosphärendruck erzeugte Ionen darin aufgebraucht werden, bevor der gasförmige Strahl durch das offene Ende (22) der Kammer (16) austritt.

12. Vorrichtung zur Abscheidung eines Materials auf ein Substrat nach Anspruch 9, worin das Strömungsgas ein O₂/He-Gemisch umfasst.

13. Vorrichtung zur Abscheidung eines Materials auf ein Substrat nach Anspruch 12, worin die gasförmige Vorläuferspezies Tetraethoxysilan umfasst und das Material SiO₂ ist.

14. Vorrichtung zur Abscheidung eines Materials auf ein Substrat nach Anspruch 12, worin 13,56 MHz HF-Energie an die zentrale Elektrode angelegt werden und die elektrisch leitende Kammer geerdet ist.

15. Vorrichtung zur Abscheidung eines Materials auf ein Substrat nach Anspruch 12, worin das Substrat Silicium ist.

## Revendications

1. Procédé pour déposer un matériau sur un substrat, comprenant les étapes de:
(a) produire une espèce de réaction dans une décharge de plasma RF sans arc, à pression atmosphérique, dans un gaz s'écoulant à travers une région annulaire (20) entre une chambre électriquement conductrice (16) ayant une extrémité fermée et une extrémité ouverte (22) et une électrode centrale (14) située dans la chambre (16) et disposée de telle sorte que la région annulaire (20) est définie entre celles-ci, par quoi lesdites espèces de réaction s'écoulent vers l'extrémité ouverte (22) de la chambre (16);
(b) introduire une espèce de précurseur gazeux dudit matériau dans les espèces de réaction dans la région de l'extrémité ouverte (22) de la chambre (16) et à l'extérieur de la région annulaire (20), ladite espèce de précurseur gazeux étant sélectionnée de telle sorte que ladite espèce de précurseur réagit avec au moins une desdites espèces réactives, par quoi un jet gazeux apte à former ledit matériau sort à travers l'extrémité ouverte (22) de la chambre (16); et
(c) placer ledit substrat dans le chemin du jet gazeux, par quoi ledit matériau est déposé sur ledit substrat.

2. Procédé pour déposer un matériau sur un substrat selon la revendication 1, où la génération des espèces réactives inclut la consommation sensiblement de tous les ions produits dans la décharge de plasma à pression atmosphérique avant que le jet gazeux ne sorte à travers l'extrémité ouverte (22) de la chambre (16).

3. Procédé pour déposer un matériau sur un substrat selon la revendication 1, où ledit gaz d'écoulement comprend un mélange O₂/He

4. Procédé pour déposer un matériau sur un substrat selon la revendication 3, où ladite espèce de précurseur gazeux comprend le tétraéthoxysilane, et ledit matériau est SiO₂.

5. Procédé pour déposer un matériau sur un substrat selon la revendication 3, où ledit substrat est du silicium.

6. Procédé pour déposer un matériau sur un substrat selon la revendication 3, où de l'énergie RF de 13,56 MHz est appliquée à l'électrode centrale (14), et la chambre électriquement conductrice (16) est mise à la masse.

7. Appareil pour déposer un matériau sur un substrat, qui comprend en combinaison:
(a) une chambre électriquement conductrice (16) ayant une extrémité fermée et une extrémité ouverte (22);
(b) une électrode centrale (14) située dans ladite chambre (16) définissant ainsi une région annulaire (20);
(c) un moyen pour faire passer les gaz à travers la région annulaire (20);
(d) un moyen (18) pour fournir de l'énergie RF soit à ladite électrode centrale (14) soit à ladite chambre électriquement conductrice (16) de telle sorte qu'une décharge de plasma continue se produit entre ladite électrode (14) et ladite chambre (16), par quoi des espèces réactives sont produits qui s'écoulent vers l'extrémité ouverte (22) de ladite chambre (16); et
(e) un moyen pour introduire une espèce de précurseur gazeux dudit matériau dans les espèces réactives dans la région de l'extrémité ouverte (22) de la chambre (16) et à l'extérieur de la région annulaire (20), ladite espèce de précurseur gazeux étant sélectionnée de façon que ladite espèce de précurseur réagit avec au moins une desdites espèces réactives, par quoi un jet gazeux apte à former ledit matériau sort à travers l'extrémité ouverte (22) de ladite chambre (16).

8. Appareil pour déposer un matériau sur un substrat selon la revendication 7, où ladite chambre électriquement conductrice (16) possède un axe longitudinal, et ladite électrode centrale (14) possède un axe longitudinal, et par quoi ladite électrode centrale (14) est disposée de telle sorte que son axe longitudinal est colinéaire avec l'axe longitudinal de ladite chambre (16).

9. Appareil pour déposer un matériau sur un substrat selon la revendication 7, où ladite électrode (14) présente des fentes longitudinales dans celle-ci, chaque fente ayant une largeur sélectionnée et une profondeur sélectionnée.

10. Appareil pour déposer un matériau sur un substrat selon la revendication 9, où chaque fente a la même largeur et la même profondeur, et où le rapport de la largeur choisie à la profondeur choisie des fentes est approximativement un à trois.

11. Appareil pour déposer un matériau sur un substrat selon la revendication 9, où la chambre (16) et l'électrode centrale (14) sont agencées pour assurer que sensiblement tous les ions produits dans la décharge de plasma à pression atmosphérique soient consommés dans celle-ci avant que le jet gazeux ne sorte à travers l'extrémité ouverte (22) de ladite chambre (16).

12. Appareil pour déposer un matériau sur un substrat selon la revendication 9, où le gaz d'écoulement comprend un mélange O₂/He.

13. Appareil pour déposer un matériau sur un substrat selon la revendication 12, où ladite espèce de précurseur gazeux comprend le tétraéthoxysilane, et ledit matériau est SiO₂.

14. Appareil pour déposer un matériau sur un substrat selon la revendication 12, où l'énergie RF de 13,56 MHz est appliquée à ladite électrode centrale, et ladite chambre électriquement conductrice est mise à la masse.

15. Appareil pour déposer un matériau sur un substrat selon la revendication 12, où ledit substrat est du silicium.
